# EUROPÄISCHE PATENTSCHRIFT

(11) **EP 0 333 208 B1**
(45) Veröffentlichungstag und Bekanntmachung des Hinweises auf die Patenterteilung: **01.06.1994**
(21) Anmeldenummer: 89104798.7
(22) Anmeldetag: 17.03.1989
(51) Int. Cl.: H01L 29/784

(54) **Dünnschichttransistor mit Lichtschutz aus amorphem Kohlenstoff und Verfahren zur Herstellung des Lichtschutzes**
Thin film transistor with an amorphous carbon light protection and method to make this light protection
Transistor en couche mince ayant une protection contre la lumière en carbone amorphe et procédé pour fabriquer cette protection

(30) Priorität: 18.03.1988 DE 3809092
(43) Veröffentlichungstag der Anmeldung: 20.09.1989
(73) Patentinhaber: Nokia (Deutschland) GmbH, 75175 Pforzheim (DE)
(72) Erfinder: Mörsch, Gilbert, Dipl.-Phys., D-7000 Stuttgart 80 (DE)

(56) Entgegenhaltungen:
- US-A- 4 609 930
- PATENT ABSTRACTS OF JAPAN vol. 10, no. 184 (E-415)(2240) 27 Juni 1986, & JP-A-61 32471
- PATENT ABSTRACTS OF JAPAN vol. 10, no. 24 (E-377)(2081) 30 Januar 1986, & JP-A-60 182773

## Beschreibung

Die Erfindung betrifft Dünnschichttransistoren, wie sie beispielsweise zur Ansteuerung von Flüssigkristallzellen in flachen Bildschirmen benutzt werden und ein Verfahren zum Aufbringen eines Lichtschutzes auf diese Dünnschichttransistoren.

Flache Bildschirme bestehen aus einer großen Zahl einzelner Bildpunkte, deren Lichtdurchlässigkeit mit Hilfe von Flüssigkristallzellen gesteuert wird. Zur Ansteuerung der einzelnen Flüssigkristallzellen gibt es zwei Möglichkeiten, von denen im folgenden nur eine, nämlich die aktive Adressierung behandelt wird. Bei dieser Art der Adressierung wird ein Dünnschichttransistor verwandt, der als Feldeffekttransistor arbeitet. Im leitenden Zustand führt der Transistor die zur Ansteuerung erforderliche Information als elektrische Ladung in die Flüssigkristallzelle oder einen zusätzlichen Speicherkondensator. Daran anschließend wird der Transistor gesperrt und die Flüssigkristallzelle wirkt wie ein Kondensator. Die gespeicherte Information befindet sich nun in Form elektrischer Ladung in dem Flüssigkristall oder einem zusätzlichen Speicherkondensator. Wird dieses Halbleitermaterial von Licht getroffen, werden in ihm Elektron-Loch-Paare generiert und der Kondensator wird so entladen. Um eine Entladung durch Licht zu verhindern, ist die Schicht aus Halbleitermaterial mit einem Lichtschutz überzogen, meistens mit einer dünnen Metallschicht. Da Metall elektrisch leitet, muß die Halbleiterschicht vor dem Aufbringen des Metallfilms mit einer isolierenden Zwischenschicht versehen werden.

Aus US-A-4609930 ist weiter ein mit einem Lichtschutz versehener Dünnschichttransistor bekannt, der abweichend zu der zuvor erörterten Anordnung im von der Drain-Elektrode, der Source-Elektrode und der lichtempfindlichen Halbleiterschicht gebildeten Raum eine Lichtschutzschicht aufweist.

Diese Schicht, welche mit Hilfe des CVD-Verfahrens hergestellt wird, ist aus amorphem Silizium und Germanium gebildet, wobei der Anteil an Germanium mindestens 30 % beträgt. Diese Lichtschutzschicht ist mit einer Isolierschicht abgedeckt, wobei die Isolierschicht auch hier mit den beiden Elektroden in Kontakt steht.

Die bekannten Dünnschichttransistoren haben den Nachteil, daß der Lichtschutz nur mit Hilfe zweier Schichten, einer Isolationsschicht und einer den Lichteinfall hindernden Schicht zu erreichen ist. Aufgabe der Erfindung ist es, einen Lichtschutz zu finden, der in einer einzigen Schicht realisiert wird. Eine weitere Aufgabe der Erfindung besteht in der Angabe eines einfachen Verfahrens zur Herstellung eines solchen Lichtschutzes.

Der erfindungsgemäße Dünnschichttransistor hat den Vorteil, daß sein Lichtschutz sowohl elektrisch isoliert als auch lichtundurchlässig ist. Er besteht aus amorphem Kohlenstoff, der in einem CVD-Prozeß mit Hilfe von Methan (CH₄) aufgebracht wird.

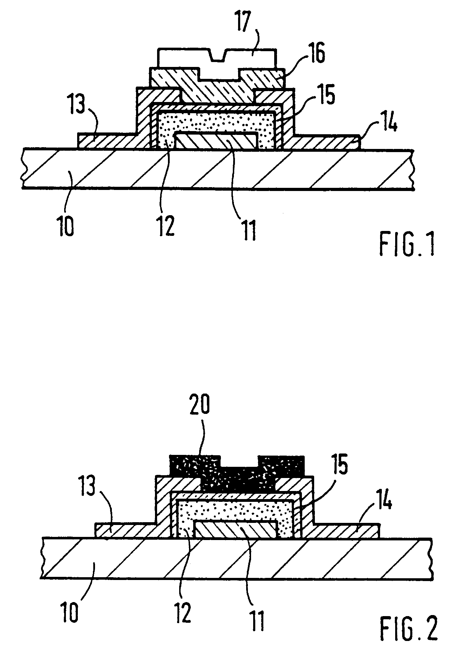

Ein Ausführungsbeispiel der Erfindung wird im folgenden beschrieben und anhand der Figuren 1 und 2 näher erläutert.

Es zeigen:
- Fig. 1: einen Dünnschichttransistor mit Metall-Lichtschutz,
- Fig. 2: einen Dünnschichttransistor mit amorphem Kohlenstoffilm.

In Fig. 1 ist mit 10 ein Glassubstrat bezeichnet, auf dem sich ein Dünnschichttransistor befindet, der aus einer Tantal-Elektrode 11, einem Gateisolator 12, einer Source-Elektrode 13, einer Drain-Elektrode 14, einem lichtempfindlichen Halbleiter 15, einer transparenten Isolationsschicht 16 und einem Metall-Lichtschutz 17 besteht. Ein solcher Dünnschichttransistor ist Bestandteil einer großen Anzahl von Dünnschichttransistoren, die in einer m x n Matrix angeordnet sind. Diese Dünnschichttransistoren dienen zur aktiven Adressierung von Flüssigkristallzellen, die ihrerseits wiederum Bestandteil eines flachen Bildschirmes sind. Die Lichtdurchlässigkeit der Flüssigkristallzellen wird mit Hilfe der Dünnschichttransistoren gesteuert. Von der Source-Elektrode 13 gelangen Ladungsträger über das lichtempfindliche Halbleitermaterial 15 zur Drain-Elektrode 14 und damit zum Flüssigkristall. Danach wird die Source-Drain-Strecke hochohmig gemacht, und der Flüssigkristall fungiert als Kondensator. Die in diesem Kondensator gespeicherte Ladung ist ein Maß für die optische Information (Helligkeit), die der einzelne Bildpunkt abgeben soll. Man entnimmt der Fig. 1, daß die Halbleiterschicht 15 nur teilweise von den beiden Elektroden 13 und 14 bedeckt ist. Daher kann licht in das Halbleitermaterial 15 eindringen. Falls Licht in das Halbleitermaterial 15 eindringt, werden dort Elektron-Loch-Paare generiert, die zu einer Entladung des Kondensators führen. Ein solcher Effekt ist nicht erwünscht. das Halbleitermaterial 15 muß gegen Lichteinfall geschützt werden. Bekannte Ausführungen von Dünnschichttransistoren benutzen dazu einen metallischen Lichtschutz, der wegen seiner elektrischen Leitfähigkeit jedoch durch eine Isolationsschicht vom Halbleiter getrennt werden muß. Die Isolationsschicht ist hier mit 16, der metallische Lichtschutz mit 17 bezeichnet. Bei der Herstellung eines solchen Transistors sind somit zwei Prozesse erforderlich, nämlich erstens das Aufbringen einer transparenten Isolationsschicht 16 und zweitens das Aufbringen eines metallischen Lichtschutzes 17.

Fig. 2 zeigt einen Dünnschichttransistor, der bis auf eine Ausnahme dem in Fig. 1 entspricht. Gleiche Bezugszeichen bezeichnen gleiche Elemente. Anstelle einer transparenten Isolationsschicht 16 und eines metallischen Lichtschutzes 17 wird hier ein Film 20 aus amorphem Kohlenstoff benutzt. Amorpher Kohlenstoff ist nichtleitend und hat eine Absorption von 99,96%. Durch die Verwendung von amorphem Kohlenstoff entfällt das Aufbringen einer zusätzlichen Isolationsschicht auf dem Transistor.

Der Film aus amorphem Kohlenstoff wird mit Hilfe eines CVD-Prozesses aufgebracht. Als Quelle für den Kohlenstoff kann Methan (CH₄) benutzt werden. Die Strukturierung des Films erfolgt entweder nach dem Liftoff-Verfahren oder mit Ätzen in einem Sauerstoffplasma.

## Patentansprüche

1. Auf einem Glassubstrat (10) aufgebrachter Dünnschichttransistor zur Ansteuerung einer Flüssigkristallzelle, mit einer aus lichtempfindlichem Halbleitermaterial (15) bestehenden Schicht, und einem diese Schicht bedeckenden Lichtschutz (17), **dadurch gekennzeichnet,** daß der Lichtschutz ein Film (20) aus amorphem Kohlenstoff ist.

2. Dünnschichttransistor nach Anspruch 1, **gekennzeichnet** durch seine Verwendung in einem flachen Bildschirm.

3. Dünnschichttransistor nach den Ansprüchen 1 und 2, **gekennzeichnet** durch seine Verwendung als Element zur aktiven Adressierung von Bildpunkten.

4. Verfahren zur Herstellung eines Dünnschichttransistors nach Anspruch 1, **gekennzeichnet** durch folgende Verfahrensschritte:
a) Aufbringen des Lichtschutzfilmes (20) aus amorphem Kohlenstoff durch einen CVD-(Chemical-Vapour-Deposition)-Prozeß,
b) Strukturierung des Films durch Liftoff-Verfahren oder Ätzen in Sauerstoffplasma.

5. Verfahren nach Anspruch 4, **dadurch gekennzeichnet,** daß zur Erzeugung des Lichtschutzfilmes (20) Methan (CH₄) verwandt wird.

## Claims

1. Thin-film transistor deposited on a glass substrate (10), as triggering means for a liquid crystal cell, comprising a layer consisting of a light-sensitive semiconductor material (15) and a light guard (17) covering the latter, **characterized in that** the light guard is a film (20) consisting of amorphous carbon.

2. Thin-film transistor according to claim 1, **characterized in that** it is used as a flat display screen.

3. Thin-film transistor according to claims 1 and 2, **characterized in that** it is used as element for actively addressing pixels.

4. Method for producing a thin-film transistor according to claim 1 characterized by the steps of
a) applying the light guard film (20) consisting of an amorphous carbon by means of a CVD (chemical vapour deposition) process;
b) structuring the film by lift-off processes or oxygen plasma etching.

5. Method according to claim 4, **characterized in that** methane (CH₄) is used for producing the light guard film (20).

## Revendications

1. Transistor à couche mince appliqué sur un substrat en verre (10) pour la commande d'une cellule à cristaux liquides, avec une couche consistant en un matériau semi-conducteur (15) photosensible et une protection anti-lumière (17) recouvrant cette couche,
**caractérisé en ce que** la protection anti-lumière est un film (20) en carbone amorphe.

2. Transistor à couche mince selon la revendication 1,
**caractérisé** par son utilisation dans un téle-écran plat.

3. Transistor à couche mince selon les revendications 1 et 2,
**caractérisé** par son utilisation comme élément pour l'adressage actif de points d'image.

4. Procédé pour la réalisation d'un transistor à couche mince selon la revendication 1,
**caractérisé** par les phases de procédé suivantes :
a) application d'un film de protection anti-lumière (20) en carbone amorphe par un procédé CVD (Chemical-Vapour-Deposition).
b) Structuration du film par procédé Liftoff ou corrodation dans du plasma d'oxygène.

5. Procédé selon la revendication 4
**caractérisé en ce que** pour la production du film de protection (20), on a utilisé du méthane (CH₄).
